# DEMANDE DE BREVET EUROPEEN

(11) **EP 0 949 511 A1**
(43) Date de publication de la demande: **13.10.1999**
(21) Numéro de dépôt: 99200799.7
(22) Date de dépôt: 15.03.1999
(51) Int. Cl.: G01R 11/24, G01F 15/00, G06M 3/12, G08B 29/04

(54) **Dispositif pour la détection de l'ouverture d'un compteur de consommation**

(30) Priorité: 06.04.1998 FR 9804414
(71) Demandeur: SCHLUMBERGER INDUSTRIES S.A., 92120 Montrouge (FR)
(72) Inventeur: Guillon, Jean-Louis, 86440 Migné-Auxances (FR)

(57) **Abrégé**

Dispositif pour la détection de l'ouverture d'un compteur, le compteur (3) comportant au moins un premier élément structurel (1) et un second élément structurel (2) dans une position relative donnée lorsque le compteur est fermé, caractérisé en ce qu'il comprend :
- un organe mobile (4) relié au premier élément (1) et prévu pour adopter un état stable ou un état instable en fonction du déplacement d'un des éléments structurels (1,2) par rapport à l'autre ;
- des moyens de maintien reliés au moins au second élément (2) et coopérant avec l'organe mobile (4) en fonction du déplacement d'un des éléments structurels (1, 2) par rapport à l'autre, de manière à le maintenir dans son état instable et à permettre son passage à son état stable ;
- des moyens de détection (16, 17, 18) aptes à déterminer l'état dans lequel se trouve l'organe mobile (4) et à émettre un signal d'ouverture lorsque l'organe mobile (4) est dans un état prédéterminé.

## Description

La présente invention se rapporte à un dispositif pour la détection de l'ouverture d'un compteur, ce dernier comportant au moins un premier élément structurel et un second élément structurel dans une position relative donnée lorsque le compteur est fermé. Elle concerne aussi un compteur comportant un tel dispositif.

Les compteurs, tels que les compteurs d'électricité, sont confiés à des utilisateurs éventuellement susceptibles de les démonter pour chercher à les falsifier. C'est pourquoi, les opérateurs et les fabricants de compteurs munissent les compteurs de dispositifs permettant de déceler leur ouverture du compteur.

Un système ancien consiste à relier les éléments structurels du compteur, séparés lors de l'ouverture, par un plomb d'authentification qui est brisé lors de l'ouverture. Cette technique ne permet qu'une détection a posteriori de l'ouverture, c'est à dire susceptible de n'être éventuellement effectuée que très longtemps après l'ouverture et nécessitant de plus l'intervention d'un opérateur humain.

Le document EP 0490710 décrit une autre technique connue, qui permet une détection automatique du déplacement des éléments structurels du compteur lors de son ouverture. Le dispositif décrit comprend un circuit magnétique à rémanence comprenant au moins deux parties dont l'une a une position dépendante de celle du premier élément et dont l'autre a une position dépendante du second élément, ce circuit étant de cette façon fermé pour ladite position initiale desdits éléments et ouvert pour toute autre position de ces derniers. Le dispositif comprend de plus des moyens d'excitation du circuit magnétique lorsqu'il est fermé dans un état magnétique déterminé et des moyens de commande reliés aux moyens d'excitation, pour commander le fonctionnement de ces derniers. Enfin, le dispositif comprend des moyens de détection, propres à produire un signal de détection de déplacement en réponse à une évolution particulière de l'état du circuit magnétique sous l'effet des moyens d'excitation, ces moyens de détection comprenant avantageusement un circuit de détection monopolaire.

Un tel dispositif permet, en appliquant la séquence adéquate d'opérations de magnétisation/démagnétisation du circuit magnétique, de déceler de façon automatique, même a posteriori, un déplacement temporaire ou non des éléments structurels du compteur même si le dispositif a été temporairement privé d'énergie électrique que ce soit avant, pendant ou après l'ouverture du compteur.

Il s'avère que ce type de dispositif est d'un coût élevé (relativement au coût global du compteur) ce qui se ressent d'autant plus fortement que la tendance générale pour le prix des compteurs est à la baisse.

Le document EP 549519 décrit une autre sorte de dispositif permettant la détection de l'ouverture d'un compteur. Une came est reliée à l'une des vis du capot et est entraînée en rotation lorsque la vis est démontée. La came actionne alors un marteau qui vient frapper une lame piézo-électrique. Sous l'effet du choc, la lame piézo-électrique émet une impulsion électrique qui est enregistrée dans une mémoire.

Le document FR 2681134 décrit un dispositif d'ouverture de boîtier d'un compteur comprenant une rondelle solidaire d'une vis de fermeture du capot sur le boîtier. Une piste résistive et une piste conductrice de détection de la position angulaire de la rondelle sont prévues. La position angulaire de la rondelle est mémorisée et un microprocesseur compare la position actuelle de la rondelle à la position préalablement mémorisée. Une différence entre ces positions indique que la vis a été manipulée.

Le document EP 447615 décrit quant à lui divers dispositifs utilisant de même la détection d'un changement de position d'une vis reliant le capot au boîtier pour déduire l'ouverture (ou la tentative d'ouverture) du compteur.

La présente invention propose un dispositif pour la détection de l'ouverture d'un compteur comportant au moins un premier élément structurel et un second élément structurel dans une position relative donnée lorsque le compteur est fermé et qui présente un faible coût (relativement au coût global du compteur), tout en préservant les possibilités de détection automatique d'ouverture même en cas de rupture d'alimentation électrique du dispositif.

Pour cela, un dispositif conforme à l'invention comprend:
- un organe mobile relié au premier élément et prévu pour adopter un état stable ou un état instable en fonction du déplacement d'un des éléments structurels par rapport à l'autre ;
- des moyens de maintien reliés au moins au second élément et coopérant avec l'organe mobile en fonction du déplacement d'un des éléments structurels par rapport à l'autre, de manière à le maintenir dans son état instable et à permettre son passage à son état stable.
- des moyens de détection aptes à déterminer l'état dans lequel se trouve l'organe mobile et à émettre un signal d'ouverture lorsque l'organe mobile est dans un état prédéterminé.

Selon une variante de réalisation, les moyens de maintien comprennent un doigt solidaire du second élément coopérant avec une gâchette reliée au premier élément.

De manière avantageuse, la gâchette est montée sur un ressort mince venant en appui sur le doigt lorsque le compteur est fermé.

Selon une autre variante de réalisation, la gâchette coopère avec un ressort principal solidaire du premier élément, ledit ressort principal venant en appui sur le doigt lorsque le compteur est fermé.

Dans un mode de réalisation particulier, les moyens de détection comportent un contact électrique solidaire de l'organe mobile, un autre contact électrique, ces contacts formant interrupteur et un circuit pour déterminer si ledit interrupteur est ouvert ou fermé.

L'organe mobile peut être une lame coopérant avec un moyen de rappel apte à ramener ladite lame dans sa position stable.

De manière alternative, l'organe mobile peut être une lame piézo-électrique, ou encore une lame thermoélectrique.

De manière préférée, un dispositif conforme à l'invention comprend des moyens de commande reliés aux moyens de détection pour commander le retour de l'organe mobile dans l'un de ses états, suite à l'émission d'un signal d'ouverture par les moyens de détection, lorsque l'organe mobile a adopté l'autre état suite au déplacement d'un des éléments structurels par rapport à l'autre.

La présente invention se rapporte aussi à un compteur comportant un dispositif comportant l'une au moins des caractéristiques présentées ci-dessus.

D'autres caractéristiques et avantages de l'invention ressortiront clairement de la description qui en est faite ci-après, à titre indicatif et nullement limitatif, en référence au dessin annexé, sur lequel:
- la figure 1 est un schéma général d'un dispositif conforme à l'invention, selon une première variante de réalisation;
- la figure 2 représente schématiquement le dispositif de la figure 1 lorsqu'on ouvre le compteur ;
- la figure 3 représente schématiquement le dispositif de la figure 1 lorsqu'on referme le compteur ;
- la figure 4 représente schématiquement le dispositif de la figure 1 après réinitialisation;
- la figure 5 représente schématiquement une seconde variante de réalisation d'un dispositif conforme à l'invention;
- la figure 6 représente schématiquement et partiellement une autre variante de réalisation d'un dispositif conforme à l'invention;
- la figure 7 représente schématiquement et partiellement une autre variante de réalisation d'un dispositif conforme à l'invention

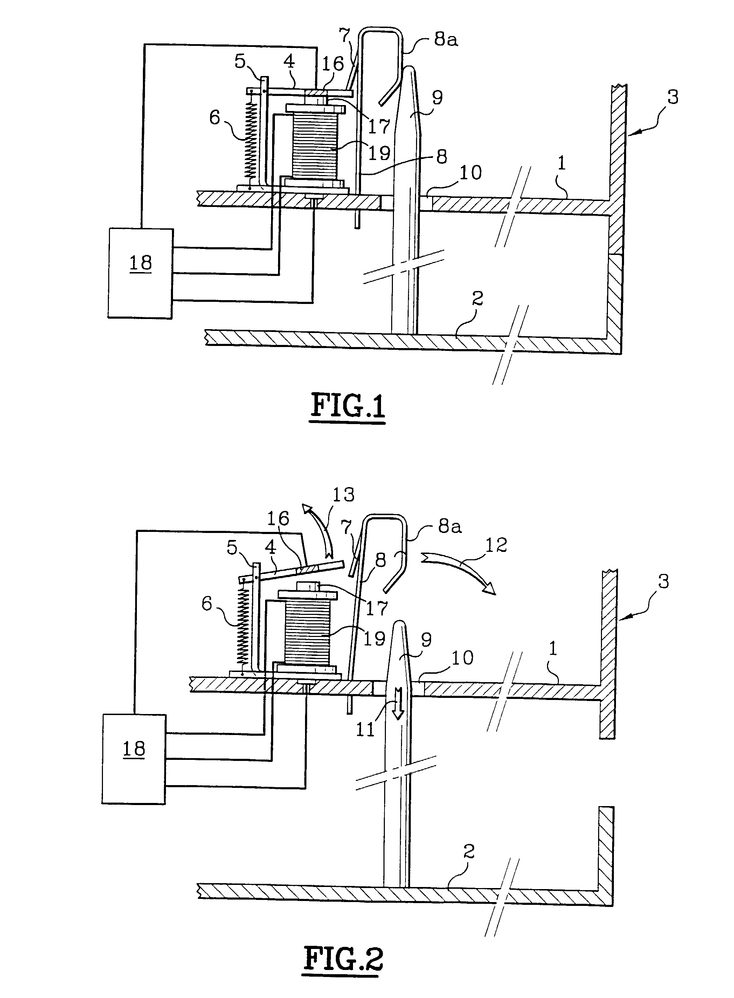

Le dispositif de l'invention permet de détecter le déplacement, à partir d'une position initiale relative de deux éléments structurels 1 et 2 d'un compteur 3, représentés schématiquement et en coupe sur la figure 1.

Pour cela, d'une manière générale et comme on le verra plus en détail dans la suite de la description, une mémoire mécanique à deux états est maintenue dans un premier état en service normal et placée dans un second état lors de l'ouverture du compteur. Le second état est conservé même après la fermeture du compteur jusqu'à la détection de l'ouverture et la réinitialisation de la mémoire mécanique, c'est à dire son retour dans son premier état.

Par exemple, le compteur 3 est un compteur d'énergie électrique représenté de façon partielle, l'élément 1 étant constitué par le boîtier du compteur et l'élément 2 étant un cache-bornes destiné en service normal à rester fixé au boîtier. L'invention permet donc de détecter l'ouverture du cache-bornes.

Dans l'exemple de réalisation représenté sur la figure 1, on voit que le dispositif comprend des moyens 4, 5, 6 reliés à l'élément 1 et partie de la mémoire mécanique à deux états. Ces moyens comportent un organe mobile 4 apte à pivoter autour d'un axe perpendiculaire au plan de la figure et fixé à une armature 5. L'organe mobile 4, ici une palette ou une lame, est apte à pivoter entre un état instable, dans laquelle il est maintenu sur la figure 1, et un état stable. Les moyens de rappel 6, ici un ressort, exercent une force tendant à ramener l'organe mobile 4 et à le maintenir dans sa position stable.

Sur la figure 1, le compteur est fermé et en service normal. Dans ce cas, des moyens de maintien 7, 8, 9 reliés au second élément 2 coopèrent avec l'organe mobile 4 de manière à maintenir celui-ci dans son état instable. Ces moyens de maintien comprennent, dans l'exemple de réalisation représenté, une gâchette 7 solidaire d'une lame mince 8 formant ressort fixée à l'élément 1 et ayant une partie d'extrémité 8a en appui sur un doigt 9 fixé sur le second élément 2. Le doigt 9 traverse l'élément 1 par une ouverture 10 prévue à cet effet.

De cette manière, le doigt 9 maintient la lame mince 8 en extension et la gâchette 7 appuie sur la palette 4 pour la maintenir en position instable.

Le fonctionnement du dispositif lors du déplacement relatif des éléments 1, 2 va être décrit ci-après en relation avec les figures 2, 3, 4. Les chiffres de références identiques sur les figures suivantes désignent des éléments identiques.

Sur la figure 2, on voit que le déplacement du second élément 2, et donc de l'ouverture du compteur 3, entraîne le retrait du doigt 9 comme l'indique la flèche 11, libérant ainsi l'extrémité 8a de la lame mince 8. La lame mince 8 retrouve alors sa position de repos comme l'indique la flèche 12, entraînant la gâchette qui lui est solidaire. Le retrait de la gâchette 7 entraîne la libération de l'organe mobile 4 qui, sous l'effet de la force de rappel exercée par le ressort 6, est ramené dans son état stable, comme l'indique la flèche 13.

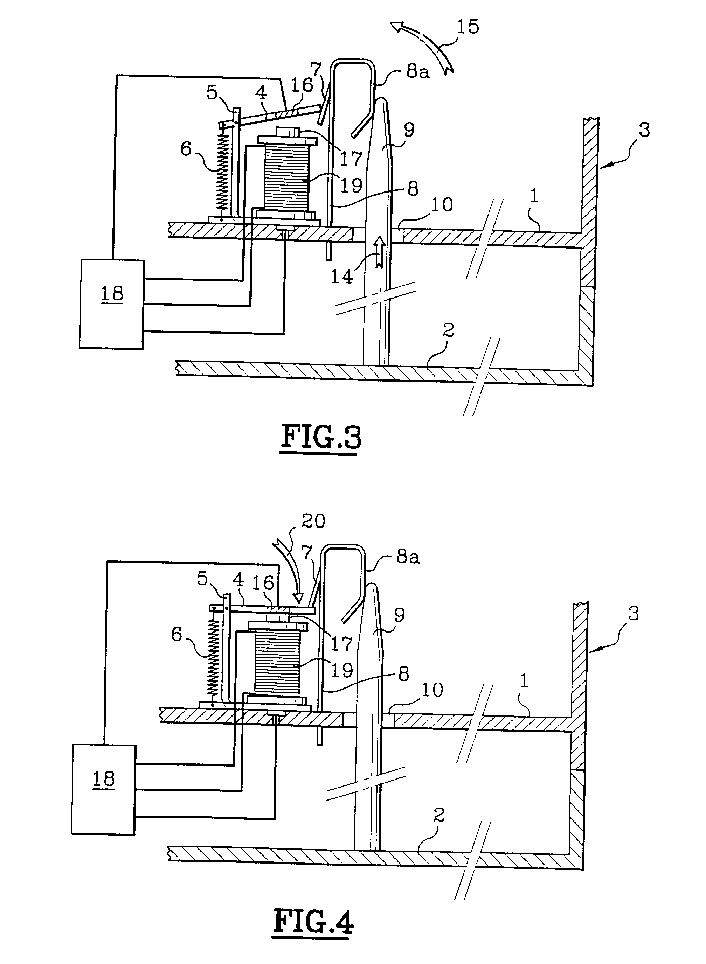

L'ouverture du compteur a donc pour effet de faire basculer l'organe mobile 4 d'un état à l'autre. La figure 3 représente schématiquement les effets de la fermeture du compteur 3, et donc de la remise en place de l'élément 2.

Cette fois, le doigt 9 pénétrant l'ouverture 10 comme l'indique la flèche 14 vient au contact de l'extrémité 8a de la lame mince 8 qui retrouve sa position d'extension comme l'indique la flèche 15. Mais l'organe mobile 4 qui est dans son état stable n'est pas repris par la gâchette 7 et conserve sa position.

L'ouverture du compteur 3, c'est à dire le déplacement de l'élément 2 par rapport à sa position initiale, entraîne le changement de position de l'organe mobile 4 mais la fermeture du compteur 3, c'est à dire le retour de l'élément 2 à sa position initiale, n'agit pas sur la position de l'organe mobile 4.

L'ouverture du compteur 3 peut donc être détectée automatiquement par simple détection du changement d'état de l'organe mobile 4 ou de manière équivalente en déterminant l'état dans lequel se trouve l'organe mobile 4.

Dans l'exemple de réalisation représenté schématiquement sur les figures 1 à 4, des moyens pour déterminer l'état de l'organe mobile 4 sont prévus et sont constitués essentiellement par un circuit électrique fermé en service normal, et ouvert lorsque l'élément 2 a été déplacé. Pour cela, un contact électrique 16 est solidaire de l'organe mobile 4. Un autre contact électrique 17 est prévu de manière à former un interrupteur avec le contact 16, ledit interrupteur étant fermé lorsque l'organe mobile 4 est maintenu en position instable et ouvert lorsque l'organe mobile 4 est dans son état stable.

Les contacts 16, 17 sont reliés à un microprocesseur 18 qui sonde périodiquement, par exemple toutes les dix secondes, si l'interrupteur formé par les contacts 16, 17 est ouvert ou fermé. Si le microprocesseur 18 détecte une ouverture de cet interrupteur, l'organe mobile 4 est donc en position stable, ce qui implique que le compteur 3 est ou a été ouvert.

Ce dispositif fonctionne même si l'ouverture du compteur 3 a été réalisée lors d'une interruption de l'alimentation en électricité du compteur. En effet, le basculement d'un état à l'autre de l'organe mobile 4 est indépendant de tout apport en énergie électrique. Une fois l'alimentation revenue, le microprocesseur 18 détecte automatiquement l'ouverture du compteur 3.

Selon une variante de réalisation non représentée, les moyens pour déterminer l'état de l'organe mobile peuvent être des moyens optiques comprenant une source de lumière émettant un faisceau lumineux en direction d'un détecteur. Dans l'un de ses états, l'organe mobile vient interrompre la propagation du faisceau lumineux, tandis que dans l'autre de ses états, laisse le faisceau se propager librement. Le microprocesseur relié au détecteur peut ainsi déterminer l'état de l'organe mobile en fonction du signal émis par le détecteur.

Une ouverture du compteur 3 ayant été détectée, un signal d'ouverture est produit par le microprocesseur 18 qui permet par exemple d'incrémenter une mémoire (non représentée) dans laquelle sont comptabilisées les ouvertures successives. Ce signal d'ouverture peut aussi déclencher un signal d'alerte, l'allumage d'une diode électroluminescente (non représentée) ou un affichage d'un message d'ouverture sur un afficheur prévu à cet effet (non représenté).

De manière avantageuse, le dispositif de l'invention comprend des moyens de commande reliés au moyens de détection pour commander le retour de l'organe mobile à sa position initiale, suite à l'émission d'un signal d'ouverture par les moyens de détection.

Comme représenté sur la figure 4, ces moyens de commande comprennent, dans cette variante de réalisation, une bobine 19 reliée au microprocesseur 18. Dans ce cas, le contact 17 est constitué par l'extrémité d'un noyau magnétique plongeant dans la bobine 19. Déclenché par le signal d'ouverture, le microprocesseur 18 émet une impulsion électrique, par exemple d'une durée de quelques centaines de secondes, suffisante pour créer un champ magnétique attirant le contact 16 et donc pour ramener l'organe mobile 4 dans sa position initiale comme l'indique la flèche 20.

La gâchette 7 se positionne alors de manière à maintenir l'organe mobile 4 dans cette position, même lorsque le champ magnétique a disparu.

Le dispositif est ainsi réinitialisé et prêt à détecter une ouverture ultérieure du compteur 3.

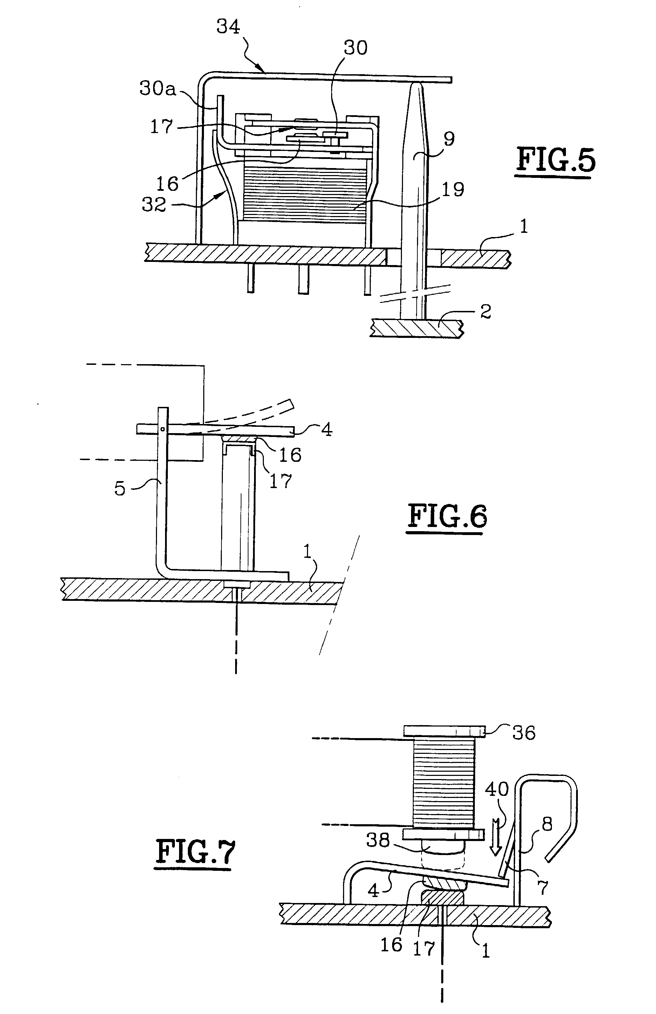

La figure 5 représente schématiquement et en coupe, une variante de réalisation d'un dispositif conforme à l'invention. Contrairement à la variante précédente, l'ouverture du compteur conduit à la fermeture de l'interrupteur formé par les contacts 16, 17.

Cette variante présente l'avantage d'écarter tout risque de faux-contact entre les contacts 16, 17 en service normal et qui conduirait à la détection erronée de l'ouverture du compteur. Un tel faux-contact peut éventuellement provenir du fait que la gâchette ne plaque pas convenablement l'organe mobile 4 sur le contact 17.

Dans l'exemple de réalisation représenté sur la figure 5, la gâchette 30 est solidaire de la bobine 19. Elle est reliée à une lame élastique 32 formant ressort de rappel, apte à entraîner la gâchette 30 selon un mouvement parallèle au plan de la figure. La figure 5 représentant le dispositif en service normal, la lame 32 est en position de repos.

En service normal, la gâchette 30 maintient l'organe mobile dont seul le contact 16 est représenté dans son état instable.

Le déplacement du doigt 9 libère une lame mince 34 formant ressort qui vient en appui sur l'extrémité 30a de la gâchette 30 en lui imposant un mouvement de retrait en translation, dégageant ainsi le contact 16.

Le second contact 17 formant interrupteur avec le contact 16 est placé en vis-à-vis de ce dernier de sorte que, lorsque la gâchette 30 libère l'organe mobile, les moyens de rappel prévus à cet effet mais non représentés ici, plaquent le contact 16 au contact 17. Les moyens de rappel peuvent être par exemple constitués par un ressort comme dans la variante précédente.

Les moyens de détection, par exemple identiques à ceux décrits précédemment (non représentés) sondent périodiquement l'état de l'interrupteur formé par les contacts 16, 17, l'état fermé indiquant une ouverture du compteur. Dans ce cas, un signal d'ouverture est alors émis ayant les mêmes effets que précédemment.

Les exemples de réalisation représentés sur les figures 1 à 4 et 5 présentent l'avantage de pouvoir être réalisés à partir de composants simples comme des relais qui comprennent les contacts nécessaires pour former l'interrupteur, des moyens de rappel, et permettent la réinitialisation du dispositif par une impulsion électrique.

Le dispositif de l'invention peut-être réalisé selon diverses autres variantes. Par exemple, les moyens de rappel 6 peuvent être constitués par un montage élastique de l'organe mobile 4 sur l'armature 5.

Selon une autre variante représentée partiellement sur la figure 6, l'organe mobile 4 peut être constitué par une lame mince piézo-électrique permettant le rappel à une position instable et participant aux moyens de commande en remplacement de la bobine 19. De manière équivalente la lame mince peut-être en matériau thermoélectrique. Dans ce cas, un bobinage placé autour de la lame permet son échauffement sous l'effet d'une impulsion électrique entraînant sa déformation, et son passage d'un état à l'autre.

La figure 7 représente schématiquement et partiellement une autre variante de réalisation d'un dispositif conforme à l'invention. Un contact 16 est disposé sur l'organe mobile 4, ici une lame mince formant ressort. Le contact 17 solidaire de l'élément est placé en vis-à-vis du contact 16 de manière à former un interrupteur, fermé lorsque la lame est maintenue en position instable par la gâchette 17, ouvert sinon.

Après déplacement de l'élément 2 (non représenté), la gâchette 7 libère la lame 4, ouvrant l'interrupteur. L'ouverture une fois détectée, le nombre d'ouvertures incrémentées et éventuellement des signaux d'alarme émis, des moyens de commande réinitialisent le dispositif, le microprocesseur (non représenté sur la figure 7) transmet un signal électrique approprié à une bobine 36 de sorte que le noyau plongeur 38 se déplace dans le sens de la flèche 40 de manière à ramener l'organe mobile 4 dans son état instable.

Quelle que soit la variante adoptée, le dispositif de l'invention permet de déceler automatiquement l'ouverture d'un compteur, y compris en cas de rupture momentanée de l'alimentation électrique du dispositif et ceci pour un faible coût. De plus, un tel dispositif peut être réalisé avec des éléments facilement adaptés à partir de composants disponibles dans le commerce.

## Revendications

1. Dispositif pour la détection de l'ouverture d'un compteur, le compteur (3) comportant au moins un premier élément structurel (1) et un second élément structurel (2) dans une position relative donnée lorsque le compteur est fermé, caractérisé en ce qu'il comprend:
- un organe mobile (4) relié au premier élément (1) et prévu pour adopter un état stable ou un état instable en fonction du déplacement d'un des éléments structurels (1,2) par rapport à l'autre;
- des moyens de maintien reliés au moins au second élément (2) et coopérant avec l'organe mobile (4) en fonction du déplacement d'un des éléments structurels (1, 2) par rapport à l'autre, de manière à le maintenir dans son état instable et à permettre son passage à son état stable.
- des moyens de détection (16, 17, 18) aptes à déterminer l'état dans lequel se trouve l'organe mobile (4) et à émettre un signal d'ouverture lorsque l'organe mobile (4) est dans un état prédéterminé.
- des moyens de commande (18, 19, 36, 38) reliés aux moyens de détection (16, 17, 18) pour commander le retour de l'organe mobile (4) dans l'un de ses états, suite à l'émission d'un signal d'ouverture par les moyens de détection (18), lorsque l'organe mobile (4) a adopté l'autre état suite au déplacement d'un des éléments structurels (1,2) par rapport à l'autre.

2. Dispositif selon la revendication 1 caractérisé en ce que les moyens de maintien comprennent un doigt (9) solidaire du second élément (2) coopérant avec une gâchette (7, 30) reliée au premier élément (1).

3. Dispositif selon la revendication 2 caractérisé en ce que la gâchette (7) est montée sur un ressort mince (8) venant en appui sur le doigt (9) lorsque le compteur (3) est fermé.

4. Dispositif selon la revendication 2 caractérisé en ce que la gâchette (30) coopère avec un ressort principal (34) solidaire du premier élément (1), ledit ressort principal (34) venant en appui sur le doigt (9) lorsque le compteur (3) est fermé.

5. Dispositif selon l'une quelconque des revendications 1 à 4 caractérisé en ce que les moyens de détection comportent un contact électrique (16) solidaire de l'organe mobile (4), un autre contact électrique (17), les contacts électriques (16, 17) formant interrupteur et un circuit (18) pour déterminer si ledit interrupteur est ouvert ou fermé.

6. Dispositif selon l'une quelconque des revendications 1 à 5 caractérisé en ce que l'organe mobile (4) est une lame coopérant avec un moyen de rappel (6) apte à ramener ladite lame dans sa position stable.

7. Dispositif selon l'une quelconque des revendications 1 à 5 caractérisé en ce que l'organe mobile (4) est une lame piézo-électrique.

8. Dispositif selon l'une quelconque des revendications 1 à 5 caractérisé en ce que l'organe mobile (4) est une lame thermoélectrique.

9. Compteur comportant un dispositif selon l'une quelconque des revendications 1 à 8.
